# EUROPEAN PATENT SPECIFICATION

(11) **EP 3 243 662 B1**
(45) Date of publication and mention of the grant of the patent: **17.04.2019**
(21) Application number: 17159251.2
(22) Date of filing: 03.03.2017
(51) Int. Cl.: B41J 2/045, B05C 5/00

(54) **FLUID EJECTION DEVICE**
FLÜSSIGKEITSAUSSTOSSVORRICHTUNG
DISPOSITIF D'ÉJECTION DE FLUIDE

(30) Priority: 03.03.2016 JP 2016040814
(43) Date of publication of application: 15.11.2017
(73) Proprietor: Seiko Epson Corporation, Tokyo 160-8801 (JP)
(72) Inventor: SUGAI, Keigo, Suwa-shi, Nagano 392-8502 (JP)
(74) Representative: Miller Sturt Kenyon

(56) References cited:
- DE-A1-102011 108 799
- US-A1- 2006 256 164

## Description

### BACKGROUND

### 1. Technical Field

The present invention relates to a fluid ejection device.

### 2. Related Art

There has been known a fluid ejection device adapted to discharge to fly a droplet material using reciprocation of a moving object. In many cases, an actuator using a piezoelectric element or the like is used as a drive source for translating the moving object. Since the piezoelectric element can generate only a small amount of displacement, the amount of displacement is amplified via an amplification mechanism in the technology described in, for example, JP-T-2014-525831 (the term "JP-T" as used herein means a published Japanese translation of a PCT patent application).

However, if the amplification mechanism is used, the configuration becomes complicated, and there is a possibility of incurring growth in size of the drive device. Therefore, there has been desired a technology capable of providing a sufficient amount of displacement of a moving object without using the amplification mechanism in a fluid ejection device for discharging a droplet using reciprocation of the moving object.

### SUMMARY

An advantage of some aspects of the invention is to solve at least a part of the problems described above, and the invention can be implemented as the following forms.

According to the invention, a fluid ejection device comprising the features of claim 1 is provided. The fluid ejection device is a fluid ejection device adapted to eject a fluent material, the fluid ejection device including a fluent material chamber supplied with the fluent material, a moving object, which can reciprocate in the fluent material chamber, a nozzle part having a discharge port communicating with the fluent material chamber, and an inner wall on a periphery of the discharge port on which a tip part of the moving object can contact from the fluent material chamber side, an actuator having contact with a back end part of the moving object to reciprocate the moving object to thereby discharge the fluent material from the discharge port, and a drive signal supply section adapted to output a signal used to drive the actuator, wherein the actuator includes a first piezoelectric element and a second piezoelectric element connected in series to each other, an end of the second piezoelectric element having contact (which may be indirect contact) with the back end part of the moving object, the drive signal supply section is capable of outputting a first drive waveform and a second drive waveform having a voltage change part steeper than a voltage change part included in the first drive waveform respectively to the first piezoelectric element and the second piezoelectric element, and the drive signal supply section outputs the second drive waveform to the second piezoelectric element in a case of outputting the first drive waveform to the first piezoelectric element, and outputs the first drive waveform to the second piezoelectric element in a case of outputting the second drive waveform to the first piezoelectric element. According to the fluid ejection device having such a configuration, since the actuator for reciprocating the moving object is formed of a plurality of piezoelectric elements connected in series to each other, the sufficient displacement amount of the moving object can be obtained without using an amplification mechanism. Further, since it is possible to output the second drive waveform having the steep voltage change part to each of the first piezoelectric element and the second piezoelectric element, it is possible to prevent that the first piezoelectric element alone is deteriorated. Therefore, the durability of the actuator is improved.

In the fluid ejection device according to the aspect of the invention, the drive signal supply section may make the tip part of the moving object come closer to the inner wall using at least a part of the first drive waveform, and the tip part of the moving object collide with the inner wall using the steeper voltage change part of the second drive waveform. According to such a configuration, since it is possible to make the moving object collide with the inner wall at high speed while keeping the sufficient stroke amount for filling the chamber with the fluent material, it is possible to discharge the material high in viscosity.

In the fluid ejection device according to the aspect of the invention, the drive signal supply section may start outputting the second drive waveform after outputting the first drive waveform with respect to each of the first piezoelectric element and the second piezoelectric element. According to such a configuration, it is possible to reduce the generation of the unwanted vibration in the actuator compared to the case in which the first drive waveform and a part of the second drive waveform are output in an overlapping manner.

In the fluid ejection device according to the aspect of the invention, that the drive signal supply section may be provided with a first drive signal supply section adapted to output the first drive waveform and the second drive waveform to the first piezoelectric element, and a second drive signal supply section adapted to output the first drive waveform and the second drive waveform to the second piezoelectric element. According to such a configuration, since it is possible to supply the drive signals individually to the first piezoelectric element and the second piezoelectric element, even if the first piezoelectric element and the second piezoelectric element are different in characteristics, it is possible to make the elements perform the expansion and contraction actions corresponding to the respective characteristics.

In the fluid ejection device according to the aspect of the invention, the first piezoelectric element and the second piezoelectric element may be equal in resonance frequency to each other. According to such a configuration, it is possible to make the first piezoelectric element and the second piezoelectric element perform substantially the same expansion and contraction action as each other. Therefore, the control of the expansion and contraction action of the actuator becomes easy.

In the fluid ejection device according to the aspect of the invention, the first drive waveform to be output to the first piezoelectric element and the first drive waveform to be output to the second piezoelectric element may be the same as each other, and the second drive waveform to be output to the first piezoelectric element and the second drive waveform to be output to the second piezoelectric element may be the same as each other. According to such a configuration, since it is possible to use the drive waveforms common to the first piezoelectric element and the second piezoelectric element, it becomes easy to control the expansion and contraction action of the actuator.

In the fluid ejection device according to the aspect of the invention, the piezoelectric elements as a plurality of piezoelectric elements may be connected to each other via a contact part, and the contact part may have one of point contact and line contact with each of the first piezoelectric element and the second piezoelectric element. According to such a configuration, since the mutual heat generation of the piezoelectric elements does not affect each other, the durability of the piezoelectric elements is improved.

The fluid ejection device according to the aspect of the invention may further include a biasing member adapted to bias the moving object in a direction from the discharge port toward the actuator. According to such a configuration, since the preliminary load can be applied by the biasing member to the piezoelectric elements, the durability of the piezoelectric elements is improved.

It should be noted that the invention can be implemented in a variety of forms such as a fluid ejection system, or a method of ejecting a fluid.

### BRIEF DESCRIPTION OF THE DRAWINGS

Embodiments of the invention will now be described by way of example only with reference to the accompanying drawings, wherein like numbers reference like elements.
Fig. 1 is a schematic configuration diagram of a fluid ejection system including a fluid ejection device according to a first embodiment of the invention.
Fig. 2 is a diagram showing a schematic shape of a drive waveform.
Fig. 3 is an explanatory diagram showing changes in state until a fluent material is discharged.
Fig. 4 is an explanatory diagram showing changes in state until a fluent material is discharged.
Fig. 5 is a schematic configuration diagram of a fluid ejection device according to a second embodiment.

### DESCRIPTION OF EXEMPLARY EMBODIMENTS

### A. First Embodiment

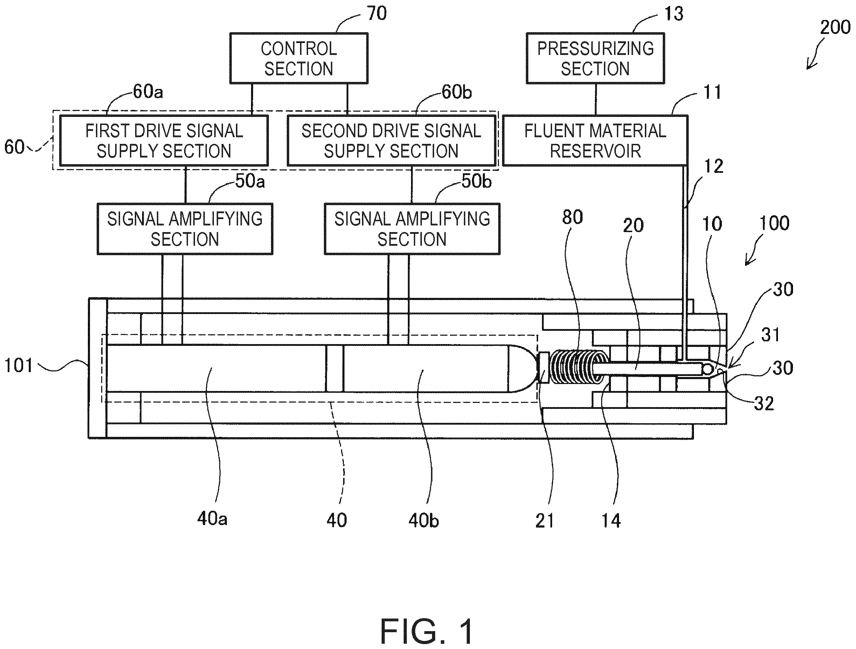

Fig. 1 is a schematic configuration diagram of a fluid ejection system 200 including a fluid ejection device 100 according to a first embodiment of the invention. The fluid ejection device 100 is, for example, a device used for a printer, and a device for discharging a minute amount of a variety of fluent materials in a range from a fluent material low in viscosity such as water, a solvent, or a reagent to a fluent material high in viscosity such as a solder paste, a silver paste, or an adhesive at high speed irrespective of presence or absence of a filler.

The fluid ejection system 200 is provided with the fluid ejection device 100, a fluent material reservoir 11, a flow channel 12, a pressurizing section 13, a drive signal supply section 60, and a control section 70. The fluid ejection device 100 is provided with a fluent material chamber 10, a moving object 20, a nozzle part 30, an actuator 40, and a biasing member 80. It should be noted that the fluid ejection system 200 can also be figured out as (considered to be) a fluid ejection device in a broad sense.

In the fluent material chamber 10, there is reserved a fluent material. The fluent material chamber 10 is supplied with the fluent material from the fluent material reservoir 11 through the flow channel 12. The fluent material reserved in the fluent material reservoir 11 is pressurized by the pressurizing section 13, and is thus supplied to the flow channel 12. In the fluent material chamber 10, there is disposed a tip part of the moving object 20 capable of reciprocating in the fluent material chamber 10. Further, on one side surface of the fluent material chamber 10, there is disposed the nozzle part 30 at a position opposed to the tip side of the moving object 20.

The nozzle part 30 has a discharge port 31 communicating with the fluent material chamber 10. The tip part of the moving object 20 is capable of having contact with an inner wall 32 on the periphery of the discharge port 31 from the fluent material chamber 10 side. The inner wall 32 is tilted to form a tapered shape. Due to the collision of the moving object 20 to the part having the tapered shape, the fluent material in the fluent material chamber 10 is discharged from the nozzle part 30.

The moving object 20 is, for example, a rod-like member having a tip shaped like a plane or a sphere, or having a tip provided with a projection. The moving object 20 is provided with the biasing member 80 in a back end part. The biasing member 80 biases the moving object 20 in a direction from the discharge port 31 toward the actuator 40. More specifically, the biasing member 80 is disposed so as to be sandwiched between a flange part 21 disposed on the back end part of the moving object 20 and a wall surface 14 on the actuator 40 side of the fluent material chamber 10, and therefore, the biasing member 80 biases the moving object 20 toward the actuator 40. Due to the biasing force by the biasing member 80, a preliminary load is applied to the actuator 40 (a first piezoelectric element 40a, a second piezoelectric element 40b). In the present embodiment, the biasing member 80 is formed of a compression coil spring. It should be noted that the biasing member 80 can also be formed of a different elastic member such as a rubber spring.

The actuator 40 is provided with the first piezoelectric element 40a and the second piezoelectric element 40b connected in series to each other. An end of the second piezoelectric element 40b has contact with the back end part of the moving object 20. An end part of the first piezoelectric element 40a located on an opposite side to the moving object 20 side is fixed to a housing 101 of the fluid ejection device 100. The actuator 40 reciprocates the moving object 20 to thereby discharge the fluent material from the discharge port 31.

In the present embodiment, the first piezoelectric element 40a and the second piezoelectric element 40b are each a piezoelectric element having a rod-like shape or a block-like shape expanding and contracting in the longitudinal direction. In the present embodiment, the first piezoelectric element 40a and the second piezoelectric element 40b are piezoelectric elements having the same characteristics. Specifically, the first piezoelectric element 40a and the second piezoelectric element 40b are the same in resonance frequency, expansion speed, and maximum amount of displacement. The first piezoelectric element 40a and the second piezoelectric element 40b are bonded to each other with an adhesive. As the adhesive, there can be used, for example, epoxy resin or acrylic adhesive.

A signal amplifying section 50a is connected to the first piezoelectric element 40a, and a signal amplifying section 50b is connected to the second piezoelectric element 40b. The drive signal supply section 60 is connected to the signal amplifying sections 50a, 50b and the control section 70. The signal amplifying sections 50a, 50b output signals for driving the piezoelectric elements 40a, 40b connected to the signal amplifying sections 50a, 50b, respectively.

The drive signal supply section 60 generates drive signals for driving the actuator 40. In the present embodiment, the drive signal supply section 60 is provided with a first drive signal supply section 60a and a second drive signal supply section 60b. The first drive signal supply section 60a generates the drive signal to be supplied to the first piezoelectric element 40a. The second drive signal supply section 60b generates the drive signal to be supplied to the second piezoelectric element 40b. The drive signals generated by the drive signal supply sections 60a, 60b are amplified by the respective signal amplifying sections 50a, 50b, and are then applied to the respective piezoelectric elements 40a, 40b. Generation of the drive signals by the drive signal supply sections 60a, 60b is controlled by the control section 70.

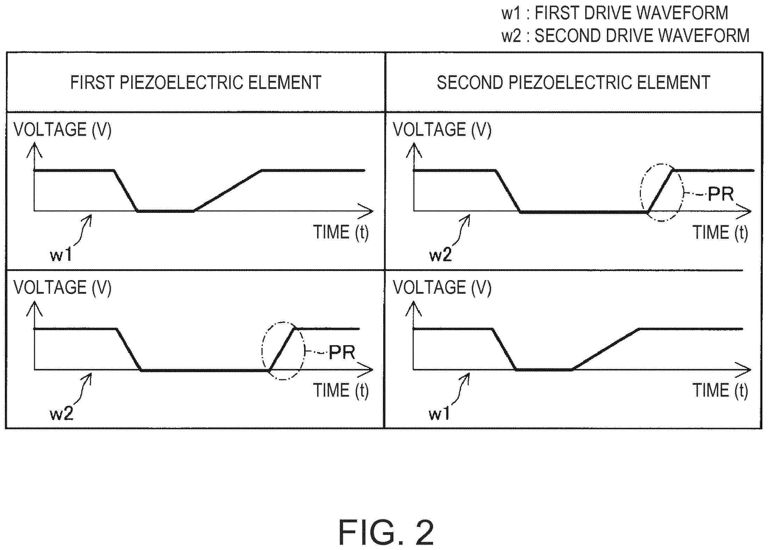

Fig. 2 is a diagram showing schematic shapes of a first drive waveform w1 and a second drive waveform w2 output to the respective piezoelectric elements 40a, 40b in the present embodiment. In the present embodiment, due to the control by the control section 70, the first drive signal supply section 60a is capable of outputting the first drive waveform w1 and the second drive waveform w2 to the first piezoelectric element 40a, and the second drive signal supply section 60b is capable of outputting the first drive waveform w1 and the second drive waveform w2 to the second piezoelectric element 40b. Further, the drive signal supply section 60 outputs the second drive waveform w2 from the second drive signal supply section 60b to the second piezoelectric element 40b in the case of outputting the first drive waveform w1 from the first drive signal supply section 60a to the first piezoelectric element 40a, and outputs the first drive waveform w1 from the second drive signal supply section 60b to the second piezoelectric element 40b in the case of outputting the second drive waveform w2 from the first drive signal supply section 60a to the first piezoelectric element 40a.

Further, the drive signal supply section 60 starts outputting the second drive waveform w2 after outputting the first drive waveform w1 with respect to each of the first piezoelectric element 40a and the second piezoelectric element 40b. Therefore, in the present embodiment, it results that the first piezoelectric element 40a and the second piezoelectric element 40b each have the first drive waveform w1 and the second drive waveform w2 alternately output to it.

In the present embodiment, the first drive waveform to be output to the first piezoelectric element 40a and the first drive waveform to be output to the second piezoelectric element 40b are the same as each other, and the second drive waveform to be output to the first piezoelectric element 40a and the second drive waveform to be output to the second piezoelectric element 40b are the same as each other. The second drive waveform w2 has a voltage change part PR steeper than a voltage change part included in the first drive waveform w1. When the steep voltage change part PR is applied to the first piezoelectric element 40a or the second piezoelectric element 40b, the moving speed of the moving object 20 is increased due to the rapid expansion of the first piezoelectric element 40a or the second piezoelectric element 40b, and thus, the fluent material 15 is discharged from the discharge port 31.

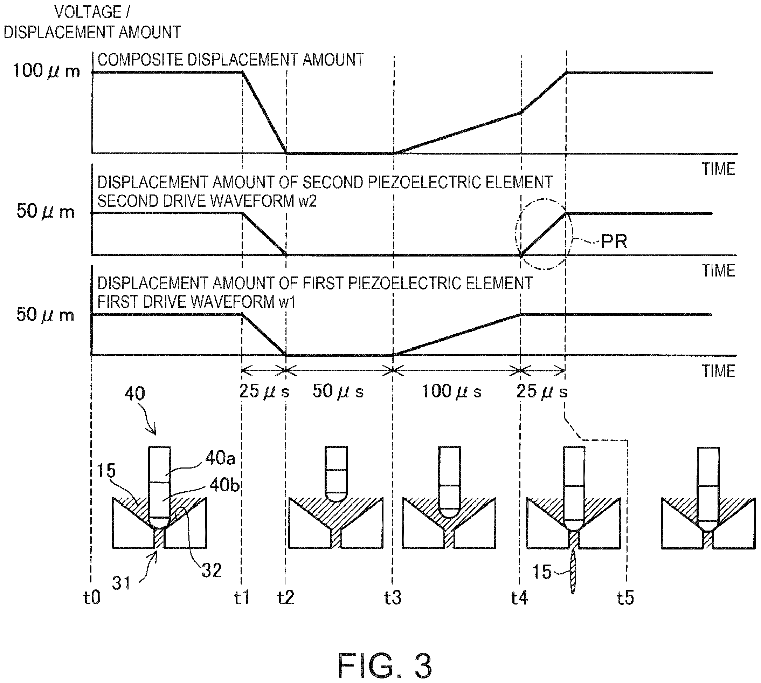

Fig. 3 is an explanatory diagram showing the state change occurring until the fluent material 15 is discharged when applying the first drive waveform w1 to the first piezoelectric element 40a and applying the second drive waveform w2 to the second piezoelectric element 40b. The horizontal axis of each of the graphs represents time (µs), and the vertical axis of the graphs represents the displacement amounts (µm) and the voltages of the piezoelectric elements 40a, 40b. The graph shown in the highest area represents a composite displacement amount obtained by combining the displacement amount of the first piezoelectric element 40a and the displacement amount of the second piezoelectric element 40b with each other. It should be noted that the drive waveforms are simplified on the assumption that the drive waveforms behave similarly to the displacement amounts of the respective piezoelectric elements. Further, in order to show the operation of the fluid ejection device 100 in a simplified manner, in the lower part of the drawing, there is shown a condition in which the actuator 40 has direct contact with the discharge port 31 to discharge the fluent material 15.

The period from the timing t0 to the timing t1 corresponds to the state in which voltages are applied to both of the piezoelectric elements 40a, 40b, and both of the piezoelectric elements 40a, 40b are expanded to the maximum. In the period (25 µs) from the timing t1 to the timing t2, the first piezoelectric element 40a and the second piezoelectric element 40b are contracted due to fall of both of the first drive waveform w1 and the second drive waveform w2. At the timing t2, the first piezoelectric element 40a and the second piezoelectric element 40b are contracted to the minimum.

In the period (50 µs) from the timing t2 to the timing t3, there is no variation in any of the drive waveforms w1, w2 and the first piezoelectric element 40a and the second piezoelectric element 40b. In this period, the fluent material chamber 10 is filled with the fluent material 15 from the fluent material reservoir 11.

In the period (100 µs) from the timing t3 to the timing t4, the first piezoelectric element 40a is expanded due to gradual rise of the first drive waveform w1. At the timing t4, the first piezoelectric element 40a expands to the maximum displacement amount, and then, the steep voltage change part PR of the second drive waveform w2 is applied to the second piezoelectric element 40b.

In the period (25 µs) from the timing t4 to the timing t5, the second piezoelectric element 40b located on the tip side is rapidly expanded due to application of the steep voltage change part PR in the second drive waveform w2 to the second piezoelectric element 40b. Therefore, at the timing t5, the moving object 20 (not shown in Fig. 3) thus accelerated collides with the inner wall 32, and thus, the fluent material 15 is discharged from the discharge port 31.

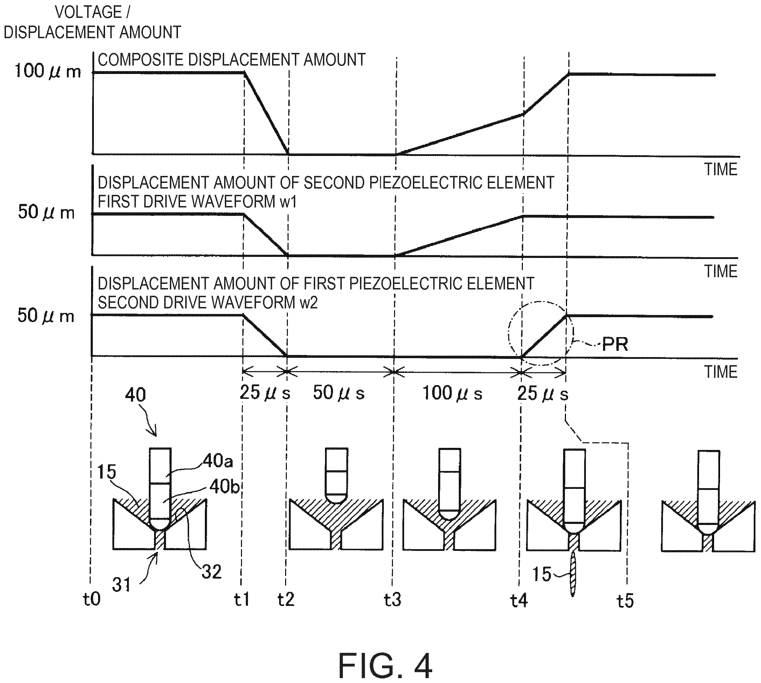

Fig. 4 is an explanatory diagram showing the state change occurring until the fluent material 15 is discharged when applying the second drive waveform w2 to the first piezoelectric element 40a and applying the first drive waveform w1 to the second piezoelectric element 40b. As shown in Fig. 4, in the case of applying the second drive waveform w2 to the first piezoelectric element 40a and applying the first drive waveform w1 to the second piezoelectric element 40b, the second piezoelectric element 40b expands first, and then the first piezoelectric element 40a expands. Even in such an operation, due to the rapid expansion of the first piezoelectric element 40a located on the back end side, the fluent material 15 is discharged from the discharge port 31.

In the present embodiment, the operation shown in Fig. 3 and the operation shown in Fig. 4 are repeatedly performed alternately once for each term in the first piezoelectric element 40a and the second piezoelectric element 40b.

According to the fluid ejection device 100 related to the present embodiment described hereinabove, since the plurality of piezoelectric elements 40a, 40b is connected in series to each other, it is possible to increase the displacement amount of the moving object 20 without using the amplification mechanism. As a result, the size of the actuator 40 can be reduced. Further, since it is possible to output the second drive waveform w2 having the steep voltage change part PR to each of the first piezoelectric element 40a and the second piezoelectric element 40b, it is possible to prevent that the first piezoelectric element 40a alone is deteriorated. Therefore, the durability of the piezoelectric element 40a is improved.

Further, in the present embodiment, due to the first drive waveform w1, the tip part of the moving object 20 is made to come closer to the inner wall 32 on the periphery of the discharge port 31, and then the tip part of the moving object 20 is made to collide with the inner wall 32 using the steep voltage change part PR of the second drive waveform w2. Therefore, since it is possible to make the moving object 20 collide with the inner wall 32 at high speed while keeping the sufficient stroke amount for filling the chamber with the fluent material 15, it is possible to discharge the material high in viscosity.

Further, in the present embodiment, since the output of the (voltage change part PR of the) second drive waveform w2 is started after outputting (and preferably finishing outputting) the (voltage change part of the) first drive waveform w1 to each of the piezoelectric elements 40a, 40b, it is possible to reduce the generation of the unwanted vibration in the actuator 40 compared to the case in which the first drive waveform w1 and a part of the second drive waveform w2 are output in an overlapping manner.

Further, since in the present embodiment, it is possible to supply the drive signals individually from the drive signal supply sections 60a, 60b to the first piezoelectric element 40a and the second piezoelectric element 40b, even if the first piezoelectric element 40a and the second piezoelectric element 40b are different in characteristics, it is possible to make the elements perform the expansion and contraction actions corresponding to the respective characteristics.

Further, in the present embodiment, since the resonance frequencies of the first piezoelectric element 40a and the second piezoelectric element 40b are equal to each other, it is possible to make the first piezoelectric element 40a and the second piezoelectric element 40b perform the expansion and contraction actions substantially the same as each other. Therefore, the control of the expansion and contraction action of the actuator 40 becomes easy.

Further, in the present embodiment, since the first drive waveform w1 to be output to the first piezoelectric element 40a and the first drive waveform w1 to be output to the second piezoelectric element 40b are the same as each other, and the second drive waveform w2 to be output to the first piezoelectric element 40a and the second drive waveform w2 to be output to the second piezoelectric element 40b are the same as each other, it is possible to use the drive waveforms common to the first piezoelectric element 40a and the second piezoelectric element 40b. Therefore, the control of the expansion and contraction action of the actuator 40 becomes easy.

Further, in the present embodiment, since the preliminary load is applied by the biasing member 80 to the piezoelectric elements 40a, 40b, the durability of the piezoelectric elements 40a, 40b is improved.

### B. Second Embodiment

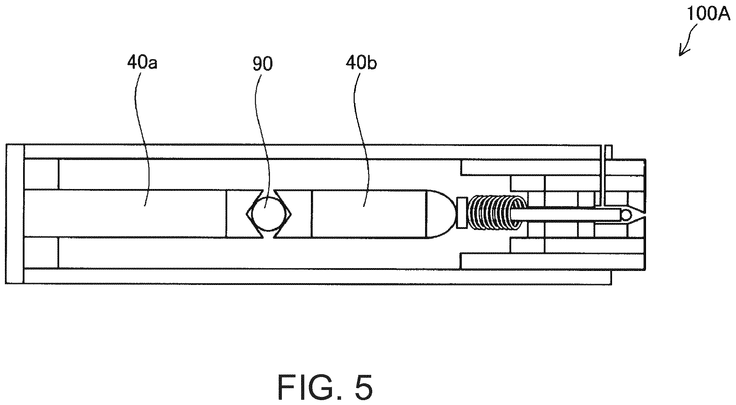

Fig. 5 is a schematic configuration diagram of a fluid ejection device 100A according to a second embodiment of the invention. The fluid ejection device 100A according to the present embodiment is different from the first embodiment in the point that the piezoelectric elements 40a, 40b are connected to each other via a contact part 90, and is the same as the first embodiment in the rest of the configuration.

The fluid ejection device 100A according to the present embodiment is provided with the contact part 90 shaped like a true sphere. The end surfaces of the first piezoelectric element 40a and the second piezoelectric element 40b having contact with the contact part 90 are each recessed to form a tapered shape such as a cone. Therefore, the contact part 90 and each of the piezoelectric elements 40a, 40b have line contact with each other. The contact part 90 is a rigid body, and is formed of metal or ceramic.

According to the fluid ejection device 100 related to the present embodiment described hereinabove, since mutual heat generation of the piezoelectric elements 40a, 40b does not affect each other, the durability of the piezoelectric elements 40a, 40b is improved.

### C. Modified Examples

### First Modified Example

In each of the embodiments described above, the first piezoelectric element 40a and the second piezoelectric element 40b are not required to be equal to each other in resonance frequency, expansion speed, or maximum displacement amount. The first drive waveform and the second drive waveform applied to the first piezoelectric element 40a, and the first drive waveform and the second drive waveform applied to the second piezoelectric element 40b can also be different drive waveforms from each other in accordance with the resonance frequencies, the expansion speeds, and the maximum displacement amounts of the respective piezoelectric elements so that the piezoelectric elements behave in the same way.

### Second Modified Example

In each of the embodiments described above, the moving object 20 and the second piezoelectric element 40b can also be bonded with an adhesive without disposing the biasing member 80.

### Third Modified Example

In each of the embodiments described above, the application operations shown in Fig. 3 and Fig. 4 can be switched alternately every time, or can also be switched after performing each of the application operations two or more times. Further, it is not required to make uniform the number of times of the operation shown in Fig. 3 and the number of times of the operation shown in Fig. 4.

### Fourth Modified Example

In the second embodiment, it is also possible to use a flat surface or another surface as the end surface of each of the first piezoelectric element 40a and the second piezoelectric element 40b having contact with the contact part 90 to thereby make the contact part 90 and each of the piezoelectric elements 40a, 40b have point contact with each other. Further, it is also possible to make one have point contact with each other, and the other have line contact with each other.

The invention is not limited to the embodiments and the modified examples described above, but can be implemented with a variety of configurations within the scope of the invention as defined by the claims.

## Claims

1. A fluid ejection device (200) adapted to eject a fluent material comprising:
a fluent material chamber (10) configured to be supplied with the fluent material;
a moving object (20), which can reciprocate in the fluent material chamber;
a nozzle part (30) having a discharge port (31) communicating with the fluent material chamber, and an inner wall (32) on a periphery of the discharge port on which a tip part of the moving object can contact from the fluent material chamber side;
an actuator (40) having contact with a back end part of the moving object to reciprocate the moving object to thereby discharge the fluent material from the discharge port; and
a drive signal supply section (60a, 60b) adapted to output a signal used to drive the actuator, **characterized in that** the actuator includes a first piezoelectric element (40a) and a second piezoelectric element (40b) connected in series to each other, an end of the second piezoelectric element having contact with the back end part of the moving object,
the drive signal supply section is capable of outputting a first drive waveform (w1) and a second drive waveform (w2) having a voltage change part (PR) steeper than a voltage change part included in the first drive waveform to the first piezoelectric element and the second piezoelectric element, and
the drive signal supply section is configured to output the second drive waveform to the second piezoelectric element in a case of outputting the first drive waveform to the first piezoelectric element, and outputs the first drive waveform to the second piezoelectric element in a case of outputting the second drive waveform to the first piezoelectric element.

2. The fluid ejection device according to Claim 1, wherein
the drive signal supply section is configured to make
the tip part of the moving object come closer to the inner wall using at least a part of the first drive waveform, and
the tip part of the moving object collide with the inner wall using the steeper voltage change part of the second drive waveform.

3. The fluid ejection device according to Claim 1 or Claim 2, wherein
the drive signal supply section is configured to start outputting the second drive waveform after outputting the first drive waveform with respect to each of the first piezoelectric element and the second piezoelectric element.

4. The fluid ejection device according to any one of the preceding claims, wherein
the drive signal supply section is provided with a first drive signal supply section (60a) adapted to output the first drive waveform and the second drive waveform to the first piezoelectric element, and a second drive signal supply section (60b) adapted to output the first drive waveform and the second drive waveform to the second piezoelectric element.

5. The fluid ejection device according to any one of the preceding claims, wherein
the first piezoelectric element and the second piezoelectric element are equal in resonance frequency to each other.

6. The fluid ejection device according to any one of the preceding claims, wherein
the first drive waveform to be output to the first piezoelectric element and the first drive waveform to be output to the second piezoelectric element are the same as each other, and
the second drive waveform to be output to the first piezoelectric element and the second drive waveform to be output to the second piezoelectric element are the same as each other.

7. The fluid ejection device according to any one of the preceding claims, wherein
the piezoelectric elements as a plurality of piezoelectric elements are connected to each other via a contact part (90), and
the contact part has one of point contact and line contact with each of the first piezoelectric element and the second piezoelectric element.

8. The fluid ejection device according to any one of the preceding claims, further comprising:
a biasing member (80) adapted to bias the moving object in a direction from the discharge port toward the actuator.

## Patentansprüche

1. Flüssigkeitsausstoßvorrichtung (200), die ausgebildet ist, ein flüssiges Material auszustoßen, umfassend:
eine Flüssigmaterialkammer (10), die gestaltet ist, mit dem flüssigen Material versorgt zu werden;
ein bewegliches Objekt (20), das sich in der Flüssigmaterialkammer hin- und herbewegen kann;
ein Düsenteil (30) mit einer Abgabeöffnung (31), die mit der Flüssigmaterialkammer in Verbindung steht, und einer Innenwand (32) an einer Peripherie der Abgabeöffnung, an welcher ein Spitzenteil des beweglichen Objekts von der Flüssigmaterialkammerseite in Kontakt gelangen kann;
ein Stellglied (40) mit Kontakt mit einem hinteren Endteil des beweglichen Objekts, um das bewegliche Objekt hin- und herzubewegen, um dadurch das flüssige Material aus der Abgabeöffnung abzugeben; und
einen Antriebssignalzuleitungsabschnitt (60a, 60b), der ausgebildet ist, ein Signal auszugeben, das zum Antreiben des Stellglieds verwendet wird,
**dadurch gekennzeichnet, dass**
das Stellglied ein erstes piezoelektrisches Element (40a) und ein zweites piezoelektrisches Element (40b) enthält, die in Serie miteinander verbunden sind, wobei ein Ende des zweiten piezoelektrischen Elements mit dem hinteren Endteil des beweglichen Objekts in Kontakt steht,
der Antriebssignalzuleitungsabschnitt imstande ist, eine erste Antriebswellenform (w1) und eine zweite Antriebswellenform (w2) mit einem steileren Spannungsänderungsteil (PR) als ein Spannungsänderungsteil, der in der ersten Antriebswellenform enthalten ist, an das erste piezoelektrische Element und das zweite piezoelektrische Element auszugeben, und
der Antriebssignalzuleitungsabschnitt gestaltet ist, die zweite Antriebswellenform an das zweite piezoelektrische Element auszugeben, falls die erste Antriebswellenform an das erste piezoelektrische Element ausgegeben wird, und die erste Antriebswellenform an das zweite piezoelektrische Element ausgibt, falls die zweite Antriebswellenform an das erste piezoelektrische Element ausgegeben wird.

2. Flüssigkeitsausstoßvorrichtung nach Anspruch 1, wobei
der Antriebssignalzuleitungsabschnitt gestaltet ist,
das Spitzenteil des beweglichen Objekts, unter Verwendung zumindest eines Teils der ersten Antriebswellenform, näher zur Innenwand zu bringen, und
das Spitzenteil des beweglichen Objekts, unter Verwendung des steileren Spannungsänderungsteils der zweiten Antriebswellenform, mit der Innenwand kollidieren zu lassen.

3. Flüssigkeitsausstoßvorrichtung nach Anspruch 1 oder Anspruch 2, wobei
der Antriebssignalzuleitungsabschnitt gestaltet ist, die Ausgabe der zweiten Antriebswellenform nach Ausgabe der ersten Antriebswellenform in Bezug auf jedes des ersten piezoelektrischen Elements und des zweiten piezoelektrischen Elements zu starten.

4. Flüssigkeitsausstoßvorrichtung nach einem der vorangehenden Ansprüche, wobei
der Antriebssignalzuleitungsabschnitt mit einem ersten Antriebssignalzuleitungsabschnitt (60a), der ausgebildet ist, die erste Antriebswellenform und die zweite Antriebswellenform an das erste piezoelektrische Element auszugeben, und einem zweiten Antriebssignalzuleitungsabschnitt (60b), der ausgebildet ist, die erste Antriebswellenform und die zweite Antriebswellenform an das zweite piezoelektrische Element auszugeben, bereitgestellt ist.

5. Flüssigkeitsausstoßvorrichtung nach einem der vorangehenden Ansprüche, wobei
das erste piezoelektrische Element und das zweite piezoelektrische Element in der Resonanzfrequenz gleich sind.

6. Flüssigkeitsausstoßvorrichtung nach einem der vorangehenden Ansprüche, wobei
die erste Antriebswellenform, die an das erste piezoelektrische Element ausgegeben wird, und die zweite Antriebswellenform, die an das zweite piezoelektrische Element ausgegeben wird, gleich sind, und
die zweite Antriebswellenform, die an das erste piezoelektrische Element ausgegeben wird, und die zweite Antriebswellenform, die an das zweite piezoelektrische Element ausgegeben wird, gleich sind.

7. Flüssigkeitsausstoßvorrichtung nach einem der vorangehenden Ansprüche, wobei
die piezoelektrischen Elemente als eine Vielzahl von piezoelektrischen Elementen über ein Kontaktteil (90) miteinander verbunden sind, und
das Kontaktteil einen Kontaktpunkt und Linienkontakt mit jedem von dem ersten piezoelektrischen Element und dem zweiten piezoelektrischen Element hat.

8. Flüssigkeitsausstoßvorrichtung nach einem der vorangehenden Ansprüche, ferner umfassend
ein Vorspannelement (80), das ausgebildet ist, das bewegliche Objekt in einer Richtung von der Abgabeöffnung zum Stellglied vorzuspannen.

## Revendications

1. Dispositif d'éjection de fluide (200) adapté pour éjecter une matière fluide comprenant :
une chambre de matière fluide (10) configurée pour être alimentée avec la matière fluide ;
un objet mobile (20) qui peut effectuer un va-et-vient dans la chambre de matière fluide ;
une partie de buse (30) ayant un orifice de décharge (31) communiquant avec la chambre de matière fluide, et une paroi intérieure (32) sur une périphérie de l'orifice de décharge sur laquelle une partie de bout de l'objet mobile peut contacter à partir du côté de chambre de matière fluide ;
un actionneur (40) ayant un contact avec une partie d'extrémité arrière de l'objet mobile pour faire aller et venir l'objet mobile pour décharger ainsi la matière fluide à partir de l'orifice de décharge ; et
une section d'alimentation de signal d'attaque (60a, 60b) adaptée pour faire sortir un signal utilisé pour attaquer l'actionneur,
**caractérisé en ce que**
l'actionneur comprend un premier élément piézoélectrique (40a) et un deuxième élément piézoélectrique (40b) connectés en série l'un à l'autre, une extrémité du deuxième élément piézoélectrique ayant un contact avec la partie d'extrémité arrière de l'objet mobile,
la section d'alimentation de signal d'attaque est capable de faire sortir une première forme d'onde d'attaque (w1) et une deuxième forme d'onde d'attaque (w2) ayant une partie de variation de tension (PR) plus raide qu'une partie de variation de tension comprise dans la première forme d'onde d'attaque à l'attention du premier élément piézoélectrique et du deuxième élément piézoélectrique, et
la section d'alimentation de signal d'attaque est configurée pour faire sortir la deuxième forme d'onde d'attaque à l'attention du deuxième élément piézoélectrique dans un cas de sortie de la première forme d'onde d'attaque à l'attention du premier élément piézoélectrique, et fait sortir la première forme d'onde d'attaque à l'attention du deuxième élément piézoélectrique dans un cas de sortie de la deuxième forme d'onde d'attaque à l'attention du premier élément piézoélectrique.

2. Dispositif d'éjection de fluide selon la revendication 1, dans lequel
la section d'alimentation de signal d'attaque est configurée pour faire en sorte que
la partie de bout de l'objet mobile arrive plus près de la paroi intérieure en utilisant au moins une partie de la première forme d'onde d'attaque, et
la partie de bout de l'objet mobile entre en collision avec la paroi intérieure en utilisant la partie de variation de tension plus raide de la deuxième forme d'onde d'attaque.

3. Dispositif d'éjection de fluide selon la revendication 1 ou la revendication 2, dans lequel
la section d'alimentation de signal d'attaque est configurée pour commencer à faire sortir la deuxième forme d'onde d'attaque après la sortie de la première forme d'onde d'attaque compte tenu de chacun parmi les premier élément piézoélectrique et deuxième élément piézoélectrique.

4. Dispositif d'éjection de fluide selon l'une quelconque des revendications précédentes, dans lequel
la section d'alimentation de signal d'attaque est dotée d'une première section d'alimentation de signal d'attaque (60a) adaptée pour faire sortir la première forme d'onde d'attaque et la deuxième forme d'onde d'attaque à l'attention du premier élément piézoélectrique, et d'une deuxième section d'alimentation de signal d'attaque (60b) adaptée pour faire sortir la première forme d'onde d'attaque et la deuxième forme d'onde d'attaque à l'attention du deuxième élément piézoélectrique.

5. Dispositif d'éjection de fluide selon l'une quelconque des revendications précédentes, dans lequel
le premier élément piézoélectrique et le deuxième élément piézoélectrique sont égaux entre eux en fréquence de résonance.

6. Dispositif d'éjection de fluide selon l'une quelconque des revendications précédentes, dans lequel
la première forme d'onde d'attaque à faire sortir à l'attention du premier élément piézoélectrique et la première forme d'onde d'attaque à faire sortir à l'attention du deuxième élément piézoélectrique sont les mêmes l'une l'autre, et
la deuxième forme d'onde d'attaque à faire sortir à l'attention du premier élément piézoélectrique et la deuxième forme d'onde d'attaque à faire sortir à l'attention du deuxième élément piézoélectrique sont les mêmes l'une l'autre.

7. Dispositif d'éjection de fluide selon l'une quelconque des revendications précédentes, dans lequel
les éléments piézoélectriques en tant qu'une pluralité d'éléments piézoélectriques sont connectés les uns aux autres via une partie de contact (90), et
la partie de contact a un point de contact et une ligne de contact avec chacun parmi les premier élément piézoélectrique et deuxième élément piézoélectrique.

8. Dispositif d'éjection de fluide selon l'une quelconque des revendications précédentes, comprenant en outre :
un élément de précontrainte (80) adapté pour précontraindre l'objet mobile dans une direction allant de l'orifice de décharge vers l'actionneur.
